# EUROPÄISCHE PATENTSCHRIFT

(11) **EP 2 174 350 B1**
(45) Veröffentlichungstag und Bekanntmachung des Hinweises auf die Patenterteilung: **29.08.2012**
(21) Anmeldenummer: 08786603.4
(22) Anmeldetag: 30.07.2008
(51) Int. Cl.: H01L 25/07

(54) **ANORDNUNG MIT ZUMINDEST EINEM HALBLEITERBAUELEMENT, INSBESONDERE EINEM LEISTUNGSHALBLEITERBAUELEMENT ZUR LEISTUNGSSTEUERUNG HOHER STRÖME**
ARRANGEMENT COMPRISING AT LEAST ONE SEMICONDUCTOR COMPONENT, IN PARTICULAR A POWER SEMICONDUCTOR COMPONENT FOR THE POWER CONTROL OF HIGH CURRENTS
ENSEMBLE COMPORTANT AU MOINS UN COMPOSANT À SEMI-CONDUCTEUR, EN PARTICULIER UN COMPOSANT À SEMI-CONDUCTEUR DE PUISSANCE, POUR LA COMMANDE DE PUISSANCE DE COURANTS DE HAUTE INTENSITÉ

(30) Priorität: 01.08.2007 DE 102007036048
(43) Veröffentlichungstag der Anmeldung: 14.04.2010
(60) Teilanmeldung: 10015490.5
(73) Patentinhaber: Siemens Aktiengesellschaft, 80333 München (DE)
(72) Erfinder: SCHIMETTA, Gernot, 81541 München (DE); SELIGER, Norbert, 85604 Zorneding (DE)
(86) Internationale Anmeldenummer: PCT/EP2008/059968
(87) Internationale Veröffentlichungsnummer: WO 2009/016192

(56) Entgegenhaltungen:
- EP-A- 0 427 143
- EP-A- 0 828 341
- EP-A- 1 643 625
- WO-A-03/030247
- WO-A-03/032390
- US-A- 5 313 091
- US-A- 5 504 378
- US-A- 5 637 922

## Beschreibung

Die Erfindung betrifft eine Anordnung mit zumindest einem ersten und einem zweiten Halbleiterbauelement, die insbesondere die Leistungshalbleiterbauelemente zur Leistungssteuerung hoher Ströme sind. Bei dieser weist das zumindest eine Halbleiterbauelement je wenigstens zwei getrennt voneinander angeordnete elektrische Anschlussflächen auf und ist auf einem gemeinsamen Trägerkörper elektrisch isoliert von diesem angeordnet. Auf den Trägerkörper sind neben dem zumindest einen Halbleiterbauelement und von dem zumindest einen Halbleiterbauelement elektrisch isoliert eine erste und eine zweite Stromschiene befestigt. Eine elektrische Anschlussfläche des zumindest einen Halbleiterbauelements ist elektrisch mit der ersten Stromschiene verbunden. Eine andere elektrische Anschlussfläche dieser Halbleiterbauelements ist elektrisch mit der zweiten Stromschiene verbunden.

Solche Anordnungen sind, in der WO 03 032390 A1 , in der US 5313091, in der US 5504378 und in der EP 1643625 beschrieben. Eine Anordnung der beschriebenen Art wird beispielsweise für elektrische Antriebe mit Leistungen im Bereich von 10 kW bis 300 kW eingesetzt. Die Anordnungen, sog. gesteuerte Leistungsmodule, werden unter anspruchsvollen Betriebsbedingungen hinsichtlich Vibration, Temperatur, Feuchtigkeit betrieben, wobei eine möglichst hohe Zuverlässigkeit gewährleistet sein soll. Durch die Anordnung werden Akkumulator- oder Kondensatorgleichspannung verlustarm in eine Wechselspannung wechselgerichtet, Wechselspannungen zum Laden von Energiespeichern gleichgerichtet oder Spannungen auf eine andere Spannungsebene transformiert.

Anordnungen mit einem oder mehreren Halbleiterbauelementen, insbesondere zur Leistungssteuerung hoher Ströme, sind üblicherweise modular aufgebaut. Die Halbleiterbauelemente sind auf Trägeranordnungen (Substraten), meist in Form metallisierter Keramikplatten, elektrisch isolierend aufgebaut. Diese Chipmodule sind auf einem Trägerkörper in Form einer Bodenplatte, die häufig kühlbar ist, befestigt. Die Stromzuführungen zu den Halbleiterbauelementen werden in der Regel durch Drahtbrücken (sog. Bonddrähte) von den Substraten zu Anschlusspins oder -leitern in einem Gehäuserahmen letztendlich zur Oberseite des Gehäuses des Moduls geleitet. Die Stromversorgung erfolgt dann oberhalb des Gehäuses durch eine Verschienung oder Platine. Hierdurch wird auf dem Trägerkörper kein Platz für eine Stromverschienung benötigt, wodurch die Baugröße der Anordnung klein gehalten werden kann. Nachteilig hieran ist, dass die elektrischen Anschlussteile zum Teil weit oberhalb des Trägerkörpers liegen, so dass diese bei Vibrationen stark schwingen und die Verbindung zum Substrat rasch ermüden kann bzw. die Zuleitung eine vergleichsweise hohe Induktivität aufweist. Zudem ist die thermische Anbindung der Verschienung nicht optimal.

Im Betrieb der Anordnung treten aufgrund elektrischer Durchleitungs- und Schaltverluste starke Erwärmungen der Halbleiterbauelemente und der elektrischen Verbindungen, gegebenenfalls zusätzlich zu den hohen Umgebungstemperaturen von z.B. 150 °C, auf. Wegen der großen thermischen Verlustleistung ist in der Regel eine aktive Kühlung erforderlich, die z.B. ein an die Anordnung angrenzender Kühlwasserkreislauf bietet. Im Falle des Einsatzes der Anordnung in einem Hybridfahrzeug zur Kühlung eines Leistungsteils wird kostenbedingt üblicherweise der Kühlkreislauf des Verbrennungsmotors herangezogen, wodurch die Temperatur der Kühleroberfläche, gegen welche entwärmt wird, bis zu 125 °C betragen kann. Für einen sicheren Betrieb dürfen Leistungshalbleiterbauelemente an den aktiven Halbleiterübergängen lediglich Temperaturen bis 175 °C (= T_{Junction}) aufweisen.

Die beschriebenen Rahmen- und Einsatzbedingungen stellen daher hohe Anforderungen an die Aufbau- und Verbindungstechnik der Anordnung. Typischerweise sind elektrische Ausfälle des Moduls - neben dem Ausfall der Halbleiterbauelemente - vor allem durch lokale Überhitzungen und thermomechanisch bedingte Ermüdungen der Drahtbrücken insbesondere an den Übergängen Drahtbrücke-Halbleiterbauelement und Drahtbrücke-Substratoberfläche sowie Drahtbrücke-Lastanschluss verursacht.

Zur Vermeidung von elektrischen Ausfällen der Anordnung werden häufig die möglichen Schaltleistungen der Halbleiterbauelemente nur zu einem Teil ausgenutzt. Aufgrund eines notwendigen Sicherheitsaufschlags in der elektrischen Auslegung bei einer vorgegebenen Nennleistung sind derartige Anordnungen jedoch kostspielig, voluminös und dementsprechend schwer. Dies ist jedoch gerade im Hinblick auf mobile Anwendungen nachteilig.

Es ist daher Aufgabe der vorliegenden Erfindung, eine Anordnung mit Halbleiterbauelementen, insbesondere Leistungshalbleiterbauelementen zur Leistungssteuerung hoher Ströme, anzugeben, welche dauerhaft in einer stark vibrationsbelasteten und Temperaturschwankungen ausgesetzten Umgebung eingesetzt werden kann.

Diese Aufgabe wird durch eine Anordnung mit den Merkmalen des Patentanspruchs 1 gelöst. Vorteilhafte Ausführungsformen finden sich in den abhängigen Patentansprüchen wieder.

Erfindungsgemäß weisen bei einer gattungsgemäßen Anordnung die erste und/oder die zweite Stromschiene Abschnitte auf, die an gegenüberliegenden Seiten des Halbleiterbauelements angeordnet sind, wobei die mit der betreffenden Stromschiene elektrisch verbundene Anschlussfläche von beiden Abschnitten mit einem Strom beaufschlagt wird.

Die erfindungsgemäße Anordnung weist den Vorteil auf, dass die Stromschienen ebenso wie die Halbleiterbauelemente unmittelbar auf der Oberfläche des Trägerkörpers dicht nebeneinander angeordnet werden können, wodurch ein kompakter Aufbau der Anordnung ermöglicht wird und eine gute thermische Anbindung an ein Kühlsystem gewährleistet wird. Darüber hinaus wird durch das Vorsehen von Abschnitten der ersten und/oder zweiten Stromschiene an gegenüberliegenden Seiten des Halbleiterbauelements eine symmetrische Stromführung (Stromeinspeisung) zu dem Halbleiterbauelement ermöglicht. Hierdurch können lokale Strommaxima und damit Überhitzungsprobleme vermieden werden. Die erfindungsgemäße Anordnung ermöglicht es damit vorteilhafterweise, die Schaltleistung der Halbleiterbauelemente höher auszunutzen, als dies im Stand der Technik möglich ist.

Gemäß der erfindungsgemäßen Ausgestaltung sind die Abschnitte der ersten und/oder zweiten Stromschiene Schenkel der betreffenden Stromschiene, die mit einem Joch der betreffenden Stromschiene U-förmig verbunden sind. Das Halbleiterbauelement ist bei dieser Ausführungsform im Inneren der U-förmig verlaufenden Stromschiene angeordnet, wodurch die symmetrische Stromeinspeisung begünstigt wird. Zweckmäßigerweise sind die Schenkel und das Joch einstückig ausgebildet.

Gemäß der Ausbildung ist eine dritte Stromschiene isoliert auf dem Trägerkörper und abschnittsweise zwischen den gegenüberliegend des Halbleiterbauelements angeordneten Abschnitten der ersten und/oder zweiten Stromschiene vorgesehen. Die dritte Stromschiene stellt beispielsweise einen elektrischen Ausgang der Anordnung dar. Die relativ zu den Abschnitten/Schenkel der ersten und/oder zweiten Stromschiene bevorzugt symmetrisch angeordnete dritte Stromschiene begünstigt den symmetrischen Stromfluss durch die gesamte Anordnung. Hierdurch werden, wie bereits erläutert, auch in der Nähe der dritten Stromschiene lokale Strommaxima und damit Temperatur Hot-Spots vermieden.

Eine weitere Ausführungsform sieht vor, eine elektrische Verbindung einer der Anschlussflächen des Halbleiterbauelements über zwei ein- oder mehrteilige Verbindungslaschen aus je einem gebogenen oder gefalzten Metallblech vorzunehmen, welche jeweils mit ihrem einen Ende über eine Schweißverbindung mit einem der gegenüberliegenden Abschnitte einer der Stromschienen verbunden sind. Wegen der räumlichen Nähe der Stromschienen und der Halbleiterbauelemente können vorteilhafterweise kurze elektrische Verbindungen, d.h. Verbindungslaschen, verwendet werden. Im Gegensatz zu Drahtbrücken ermöglichen die Verbindungslaschen eine großflächige Verbindung zu ihrem Verbindungspartner, so dass diese bei einem üblichen Betrieb der Anordnung in einer stark vibrierenden Umgebung kaum zur Resonanz angeregt werden können. Aus diesen Gründen ist die Anordnung hervorragend zum dauerhaften Einsatz in einer stark vibrierenden Umgebung, z.B. in der Nähe eines Antriebsmotors, z.B. einer Brennkraftmaschine eines Kraftfahrzeugs, der bzw. die über dies eine heiße Umgebung darstellt, geeignet. Die Verwendung von Verbindungslaschen erlaubt weiterhin im Gegensatz zu Drahtbrücken die verlustarme Leitung großer Ströme, wobei die Gefahr von Überhitzungen vermindert ist. Die Schweißverbindung zwischen den Verbindungslaschen und den Stromschienen kann beispielsweise unter Verwendung einer Laser-, WIG-, Mikroplasmaoder Elektronenstrahlschweißverbindung erfolgen. Da Schweißverfahren im Allgemeinen eine hohe Zuverlässigkeit aufweisen, ist auch die Gefahr von elektrischen Ausfällen aufgrund einer Schwächung der elektrischen Verbindung im Bereich der Verbindungslaschen verringert.

Zweckmäßigerweise sind die zwei Verbindungslaschen mit ihrem anderen Ende jeweils mit einer von dem Trägerkörper elektrisch isolierten Zwischen-Kontaktfläche oder mit einer auf der Oberfläche der Anordnung aufgebrachten Leiterzugstruktur verschweißt. Dies ermöglicht es in vorteilhafter Weise, die Verbindungslasche auch mit ihrem anderen Ende zu verschweißen.

Eine weitere Ausgestaltung, bei der eine elektrische Verbindung zwischen der Zwischen-Kontaktfläche und der einen Anschlussfläche des Halbleiterbauelements über eine auf der Oberfläche der Anordnung aufgebrachte Leiterzugstruktur erfolgt, ermöglicht den vollständigen Verzicht auf Drahtbrücken bei der erfindungsgemäßen Anordnung. Gemäß dieser Ausbildung erfolgt die Kontaktierung unter Verwendung einer sog. planaren Verbindungstechnologie, die beispielsweise unter dem Namen SiPLIT (Siemens Planar Interconnect Technology) bekannt ist.

Die Leistungshalbleiter brauchen bei der Anordnung vorteilhafterweise nicht verkapselt (z.B. mit einem Gelverguss) zu sein, sondern können nackt auf dem Trägerkörper befestigt werden. Dennoch ist es zweckmäßig, wenn die gesamte Anordnung hermetisch dicht in einem Gehäuse eingeschlossen ist.

In einer weiteren Ausführungsform ist die Zwischen-Kontaktfläche zwischen einem der Abschnitte der ersten und/oder zweiten Stromschiene und dem zumindest einen Halbleiterbauelement angeordnet. Durch die räumliche Nähe der Zwischen-Kontaktfläche zu einem der Abschnitte der Stromschiene können die Verbindungslaschen kurz ausgeführt werden, wodurch das Schwingungsverhalten weiter begünstigt wird. Darüber hinaus wird auch durch die räumliche Nähe der Zwischen-Kontaktfläche zu dem Halbleiterbauelement die Erzeugung der Leiterzugstrukturen erleichtert.

Es kann weiter vorgesehen sein, dass eine der ZwischenKontaktflächen durch eine Kontaktfläche ausgebildet ist, auf der das zumindest eine Halbleiterbauelement elektrisch leitend angeordnet ist. Alternativ kann vorgesehen sein, eine der Zwischen-Kontaktflächen von einer Kontaktfläche elektrisch zu isolieren, auf der das zumindest eine Halbleiterbauelement elektrisch leitend angeordnet ist.

Es ist bevorzugt, wenn die Verbindungslaschen aus einem den Stromschienen entsprechenden Material gebildet sind. Hierdurch können die thermischen Ausdehnungskoeffizienten zueinander angepasst werden, wodurch die Langzeitstabilität der erfindungsgemäßen Anordnung positiv beeinflusst ist.

Die erfindungsgemäße Anordnung weist zumindest ein erstes und ein zweites zu einer Halbbrücke verschaltete Halbleiterbauelemente auf, wobei eine elektrische Anschlussfläche des ersten Halbleiterbauelements elektrisch mit der ersten, einem elektrischen Pol zugeordneten, Stromschiene verbunden ist. Eine elektrische Anschlussfläche des zweiten Halbleiterbauelements ist elektrisch mit der zweiten, dem zum einen elektrischen Pol entgegengesetzten anderen elektrischen Pol zugeordneten, Stromschiene verbunden. Die andere elektrische Anschlussfläche des ersten Halbleiterbauelements und die andere elektrische Anschlussfläche des zweiten Halbleiterbauelements sind mit einer Verbindungslasche elektrisch mit der dritten Stromschiene verbunden.

In einer nicht erfindungsgemäßen Ausbildung sind die erste und die zweite Stromschiene übereinander und voneinander elektrisch isoliert auf einer Oberfläche des Trägerkörpers angeordnet, wobei jede der ersten und der zweiten Stromschienen an jedem der Abschnitte eine freie Anschlussfläche aufweist, die jeweils mit einer Verbindungslasche verbunden ist. Durch das Übereinanderanordnen der ersten und zweiten Stromschiene lässt sich ein in seinen Abmaßen kompaktes Bauelement realisieren, das aufgrund des Verzichts auf Drahtbrücken eine nur geringe Bauhöhe aufweist. Diese sogenannte koplanare Anordnung ergibt sehr niedrige Induktivitäten und damit vergleichsweise geringe Schaltüberspannungen, die dann eine höhere Schaltleistung ermöglichen.

Bei dieser nicht erfindungsgemäßen Ausführungsform ist es zweckmäßig, wenn die freien Anschlussflächen jeweils in den gegenüberliegend des Halbleiterbauelements angeordneten Abschnitten vorgesehen sind. Ferner kann vorgesehen sein, auf den freien Anschlussflächen der ersten und der zweiten Stromschienen einen Kondensator, insbesondere einen Stützkondensator, anzuordnen, welcher eine freie Anschlussfläche der ersten Stromschiene mit einer freien Anschlussfläche der zweiten Stromschiene miteinander verbindet. Aufgrund der U-förmigen Ausgestaltung der ersten und/oder zweiten Stromschiene ergibt sich, dass für das zumindest eine Halbleiterbauelement zwei Kondensatoren vorgesehen sind.

In einem Beispiel umfasst ein Halbleiterbauelement eine Parallelschaltung aus einem Halbleiterschaltelement und einem Halbleitergleichrichterelement, wobei die Serienschaltung dieser beiden Bauelemente in einer Achse gelegen ist, welche parallel zu den gegenüberliegend des Halbleiterbauelements angeordneten Abschnitten liegt. Das Halbleitergleichrichtelement kann beispielsweise eine Freilaufdiode für das Halbleiterschaltelement darstellen. Durch die beschriebene Anordnung wird der symmetrische Stromverlauf auch bei mehreren Halbleiterbauelementen sichergestellt.

Es kann weiter vorgesehen sein, dass zwei der Halbleiterbauelemente, umfassend eine Serienschaltung aus einem Halbleiterbauelement und einem Halbleitergleichrichtelement, parallel geschaltet sind. Damit sind die gleichen Vorteile verbunden, wie sie eben beschrieben wurden.

In einer weiteren Ausbildung ist vorgesehen, dass die Oberfläche des Trägerkörpers elektrisch leitend ist und jedes der Halbleiterbauelemente, jede der Kontaktflächen und der Zwischen-Kontaktflächen durch eine Schicht aus einem elektrisch isolierenden Material auf der elektrisch leitenden Oberfläche des Trägerkörpers von dieser Oberfläche elektrisch isoliert ist. Vorteilhafterweise werden die Halbleiterbauelemente auf einem sog. DCB-Substrat oder einem AMB-Substrat aufgebracht. DCB steht für Direct Copper Bonding, AMB für Active Metal Brazing. Bei beiden Substraten werden die Halbleiterbauelemente ganzflächig auf die Substrate mit ihrer Rückseitenkontaktierung aufgelötet. Auf der Oberseite der Halbleiterbauelemente befindliche Kontakte werden bevorzugt, wie eingangs bereits beschrieben, unter Verwendung der planaren Verbindungstechnologie kontaktiert.

Es kann weiter vorgesehen sein, dass der Trägerkörper an eine Wärmesenke, z.B. einen Kühlkörper, gekoppelt ist. Die Wärmesenke kann beispielsweise durch einen Kühlkreislauf gebildet sein. Ein Kühlkörper kann beispielsweise unter der Oberfläche des Trägerkörpers thermisch mit dem Trägerkörper verbunden sein. Der Kühlkörper kann auch in den Trägerkörper integriert sein.

Die erfindungsgemäße Anordnung kann als Halbbrücke oder als Vollbrücke ausgebildet sein. Im Falle einer Vollbrücke verlaufen die Abschnitte bzw. Schenkel der ersten und/oder zweiten Stromschiene fingerartig zwischen benachbart nebeneinander angeordneten Halbbrücken und außerhalb der jeweiligen Halbbrücken. Dies bedeutet, dass bei einer Vollbrücke die erste und/oder zweite Stromschiene insgesamt vier Abschnitte bzw. Schenkel aufweist, so dass für alle Halbleiterbauelemente einer jeweiligen Halbbrücke eine symmetrische Stromeinspeisung sichergestellt ist.

Die erfindungsgemäße Anordnung lässt sich beispielsweise als Wechsel- oder Umrichtermodul verwenden. Insbesondere ist an Anwendungen im Bereich von Kraftfahrzeugen gedacht. Hierbei können beliebige elektrische Verbraucher des Kraftfahrzeugs durch die erfindungsgemäße Anordnung gespeist werden.

Die Erfindung wird nachfolgend näher anhand eines Ausführungsbeispiels in den Figuren erläutert. Es zeigen:
- Fig. 1: eine Querschnittsdarstellung einer Anordnung,
- Fig. 2: eine Draufsicht auf eine als Umrichter ausgebildete, erfindungsgemäße Anordnung mit drei Chipmodulen,
- Fig. 3: eine Draufsicht auf ein in Fig. 2 dargestelltes Chipmodul, und

- Fig. 4: ein elektrisches Ersatzschaltbild des in Fig. 3 dargestellten Chipmoduls.

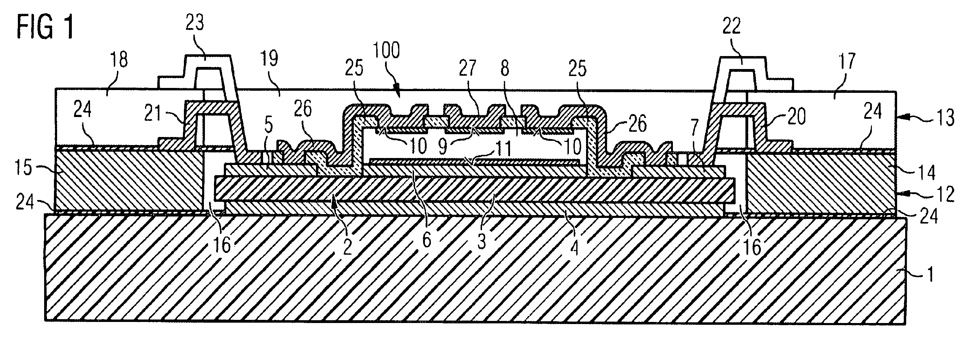

Fig. 1 zeigt eine Querschnittsdarstellung durch eine Anordnung. Auf einem Trägerkörper 1, der aus einem gut Wärme leitenden Material gebildet ist, ist eine Trägeranordnung 2 aufgebracht. Die Trägeranordnung 2 kann beispielsweise als DCB-Substrat ausgebildet sein. DCB steht für Direct Copper Bonding. Alternativ ist auch die Verwendung eines AMB-Substrats (AMB = Active Metal Brazing) denkbar. Die Trägeranordnung 2 umfasst einen Träger 3 aus einem isolierenden Material, z.B. einer Keramik, auf dessen Vorder- und Rückseite Kontaktflächen 4, 5, 6 und 7 ausgebildet sind. Die Kontaktflächen 4, 5, 6, 7 können galvanisch oder durch Aufkaschieren und Strukturieren auf den Träger 3 aufgebracht worden sein. Der Träger 3 ist über die auf seiner Rückseite angeordnete, vorzugsweise vollflächige Kontaktfläche 4 mit dem Trägerkörper 1 verbunden. Dies kann beispielsweise unter Verwendung eines Lots oder eines sonstigen Haftmittels erfolgen. Bevorzugt wird ein solches Haftmittel verwendet, welches gut Wärme leitend ist.

Die Kontaktflächen 5, 6, 7 sind voneinander elektrisch isoliert. Auf der Kontaktfläche 6 ist ein Halbleiterbauelement 8, z.B. ein Halbleiterschalter (IGBT oder MOSFET) aufgebracht. Im Ausführungsbeispiel umfasst das als Leistungshalbleiterschalter ausgebildete Halbleiterbauelement 8 drei Anschlussflächen 9, 10, 11. Mit seiner Anschlussfläche 11 ist das Halbleiterbauelement 8 elektrisch leitend mit der Kontaktfläche 6 der Trägeranordnung 2 verbunden. Die Anschlussfläche 11 stellt beispielsweise einen Lastanschluss dar. Ein weiterer Lastanschluss ist durch die Anschlussfläche 10 gebildet, welche die als Steueranschluss ausgebildete Anschlussfläche 9 umgibt.

Die Anschlussfläche 9, ist mit einer Leiterzugstruktur 27 verbunden, über welche Steuersignale an das Halbleiterbauelement 8 übertragen werden können. Die Leiterzugstruktur 27 erstreckt sich beispielsweise in die Zeichenebene hinein und endet dort auf einer in der Figur nicht sichtbaren Kontaktfläche der Trägeranordnung 2.

Die Anschlussfläche 10 des Halbleiterbauelements 8 ist über eine Leiterzugstruktur 26 mit der Kontaktfläche 5 und der Kontaktfläche 7 verbunden. Die Kontaktflächen 5 und 7 werden nachfolgend auch als Zwischen-Kontaktflächen bezeichnet, da diese zwischen dem Halbleiterbauelement 8 und einer Stromschiene 12 bzw. 13 angeordnet sind. Die Leiterzugstruktur 26 ist auf einer Isolationsschicht 25 aufgebracht, welche im Bereich der Kontaktflächen 5, 7 sowie auf der Oberseite des Halbleiterbauelements 8 im Bereich der Anschlussflächen 9 und 10 Öffnungen aufweist, so dass die Leiterzugstruktur 26 in elektrischen Kontakt mit den Anschlussflächen 9, 10 bzw. den Kontaktflächen 5, 7 gelangt.

Die Herstellung der Leiterzugstruktur 26 erfolgt unter Verwendung eines planaren Verbindungsverfahrens, welches beispielsweise unter dem Namen SiPLIT (Siemens Interconnect Planar Technology) bekannt ist.

Bei diesem wird eine Oberfläche eines Chipmoduls 100, d.h. die Einheit aus Trägeranordnung 2 und darauf aufgebrachtem oder aufgebrachten Halbleiterbauelementen, zunächst mit der Isolationsschicht 25, z.B. einer Kunststofffolie aus einem isolierenden Material, bedeckt. An den Stellen der Kontaktflächen 9, 10 sowie der Anschlussflächen 5, 7 werden Öffnungen in die Isolationsschicht 25 eingebracht, um die Kontakt- bzw. Anschlussflächen freizulegen. Anschließend wird eine dünne Metallschicht durch Sputtern, Aufdampfen und andere Verfahren zur Erzeugung dünner Kontaktschichten ganzflächig auf die Isolationsschicht und deren eingebrachte Öffnungen aufgebracht. Auf diese dünne Metallschicht wird eine weitere, in der Regel lichtempfindliche Schicht, z.B. als lichtempfindliche Folie ("Fotofolie") oder Lack, aufgebracht. Die Fotofolie wird in einem weiteren Schritt entsprechend der gewünschten leitenden Struktur belichtet und entwickelt. Bei der Entwicklung werden die nicht belichteten Abschnitte der lichtempfindlichen Schicht entfernt, so dass eine Freilegung der darunter befindlichen dünnen Metallschicht, genauer der Kupferoberfläche, erfolgt. Durch Eintauchen des vorbereiteten Halbzeugs in ein Elektrolytbad, insbesondere ein Kupfer-Elektrolytbad, wird durch galvanische Verstärkung eine ca. 20 µm bis 500 µm dicke Kupferschicht aufgewachsen. In einem sich daran anschließenden Schritt, der als Strippen der Fotofolie bezeichnet wird, wird die noch auf der Oberfläche befindliche Fotofolie an den Bereichen, an welchen keine elektrisch leitende Struktur ausgebildet werden soll, entfernt. Als letzter Schritt erfolgt ein sog. Differenzätzen, bei dem ganzflächig die aus z.B. Titan und Kupfer bestehende dünne Metallschicht entfernt wird, so dass lediglich die gewünschte leitfähige Struktur, die Leiterzugstruktur, überbleibt. Diese ist üblicherweise aus Kupfer ausgebildet, wobei die Schichtdicke im Bereich von 20 µm bis 500 µm liegt.

Zur Erhöhung der Isolationssicherheit auf der Oberfläche des Chipmoduls kann eine zweite nichtleitende Schicht aufgebracht werden, vorzugsweise als Folie oder Lack. Diese zweite Schicht bedeckt alle Bereiche des Chipmoduls mit Ausnahme der Zwischenkontaktflächen 5 und 7. Vorzugsweise reduziert diese optionale zweite Isolationsschicht auch das Eindringen von Feuchtigkeit und Sauerstoff in das Chipmodul.

Ein derart hergestelltes Chipmodul kann als separates Halbzeug hergestellt werden. Das Chipmodul 100 kann dann auf den Trägerkörper 1 aufgebracht werden.

Während die Querschnittsdarstellung der Fig. 1 suggeriert, dass das Chipmodul 100 lediglich ein einziges Halbleiterbauelement 8 aufweist, so kann ein Chipmodul in der Praxis prinzipiell eine beliebige Anzahl an Halbleiterbauelementen, gegebenenfalls auch passive Bauelemente, umfassen.

Die Stromeinspeisung des Chipmoduls 100 ist über zwei übereinander angeordnete, voneinander isolierte Stromschienen 12, 13 realisiert. Die Stromschienen 12, 13 weisen zwei parallel zueinander angeordnete, sich aus der Zeichenebene heraus erstreckende Abschnitte oder Schenkel 14, 15 bzw. 17, 18 auf, die jeweils über ein Joch 16 (Stromschiene 12) bzw. 19 (Stromschiene 13) elektrisch leitend miteinander verbunden sind. Die Schenkel 14, 15 und das Joch 16 der Stromschiene 12 sind bevorzugt einstückig aus einem elektrisch gut leitenden Material gebildet. In entsprechender Weise sind die Schenkel 17, 18 und das Joch 19 der Stromschiene 13 einstückig aus dem gleichen Material wie die Stromschiene 12 gebildet. Die Stromschiene 12 ist über eine Isolation 24 auf dem Trägerkörper 1 aufgebracht.

Abstände potentialgeführter Leiter sind derart gestaltet, dass die Vorgaben bezüglich Luft- und Kriechstrecken erfüllt werden. Dies kann insbesondere für die Stromschienen 12 und 13 bzw. die Schenkel 14, 15 und das Joch 16 bedeuten, dass ihre Kanten nicht übereinander angeordnet sind, sondern die obere Kante etwas zurückgezogen wird. Eine weitere Maßnahme wäre eine Fortsetzung des Isolators 24 über die Seitenflächen der Stromschienen 12, 13 hinweg.

Die Schenkel 15 und 18 sind benachbart zu der Zwischen-Kontaktfläche 5 des Chipmoduls 100 und die Schenkel 14, 17 benachbart zu der Zwischen-Kontaktfläche 7 des Chipmoduls 100 angeordnet. Ein freier Abschnitt des Schenkels 15 ist über eine Verbindungslasche 21 mit der Zwischen-Kontaktfläche 5 elektrisch verbunden. In entsprechender Weise ist ein freier Abschnitt des Schenkels 14 der Stromschiene 12 über eine Verbindungslasche 20 mit der Zwischen-Kontaktfläche 7 des Chipmoduls 100 elektrisch verbunden. Da sowohl die Zwischen-Kontaktfläche 5 als auch die Zwischen-Kontaktfläche 7 über die Leiterzugstruktur 26 mit der Anschlussfläche 10 elektrisch leitend verbunden sind und die Schenkel 14, 15 aufgrund der elektrischen Verbindung über das Joch 16 das gleiche Potential aufweisen, erfolgt ein symmetrischer Stromfluss von oder zu der Anschlussfläche 10 des Halbleiterbauelements. Durch die U-förmige Gestalt der Stromschienen 12, 13, welche das Chipmodul 100 im Wesentlichen vollständig umgibt, lässt sich die symmetrische Stromeinspeisung realisieren, so dass lokale Strommaxima weitestgehend vermieden werden können.

In einer alternativen Variante könnten die Verbindungslaschen 20, 21 bzw. 22, 23 auch direkt mit der Leiterzugstruktur 26 verbunden sein. Dies kann wahlweise im Bereich der ZwischenKontaktflächen 5, 7 oder auf dem Halbleiterbauelement 8 erfolgen.

In entsprechender Weise sind die Schenkel 17 und 18 der Stromschiene 13 über Verbindungslaschen 22, 23 mit einer anderen, in der Querschnittsdarstellung nicht ersichtlichen Kontaktfläche (beispielsweise zur Kontaktierung eines anderen Bauelements) des Chipmoduls 100 verbunden.

Die Verwendung von Verbindungslaschen 20, 21, 22, 23, die bevorzugt aus dem gleichen Material wie die Stromschienen 12, 13 gefertigt sind und durch einen Biege- oder Falzprozess hergestellt sind, lassen sich über eine Schweißverbindung sowohl mit den Schenkeln 14, 15 bzw. 17, 18 und den jeweiligen Kontaktflächen 5, 7 des Chipmoduls 100 verbinden. Bevorzugt wird ein Laserschweißverfahren verwendet.

Im Gegensatz zu der Verwendung von Drahtbrücken (Bonddrähten) können sich die Verbindungslaschen 20, 21, 22, 23 über die gesamte Breite der freien Anschlussflächen der Schenkel 14, 15 bzw. 22, 23 erstrecken, so dass eine geringe Stromdichte in der leitenden Schicht gegeben ist. Dieser wird weiterhin durch das verwendete Verbindungsverfahren, nämlich ein Schweißverfahren, begünstigt. Zur Vermeidung von mechanischen Spannungen an der Kontaktstelle und innerhalb der Verbindungslasche kann eine spezielle Formgebung der Laschen (Entspannungsstruktur wie von Federelementen bekannt) gewählt werden.

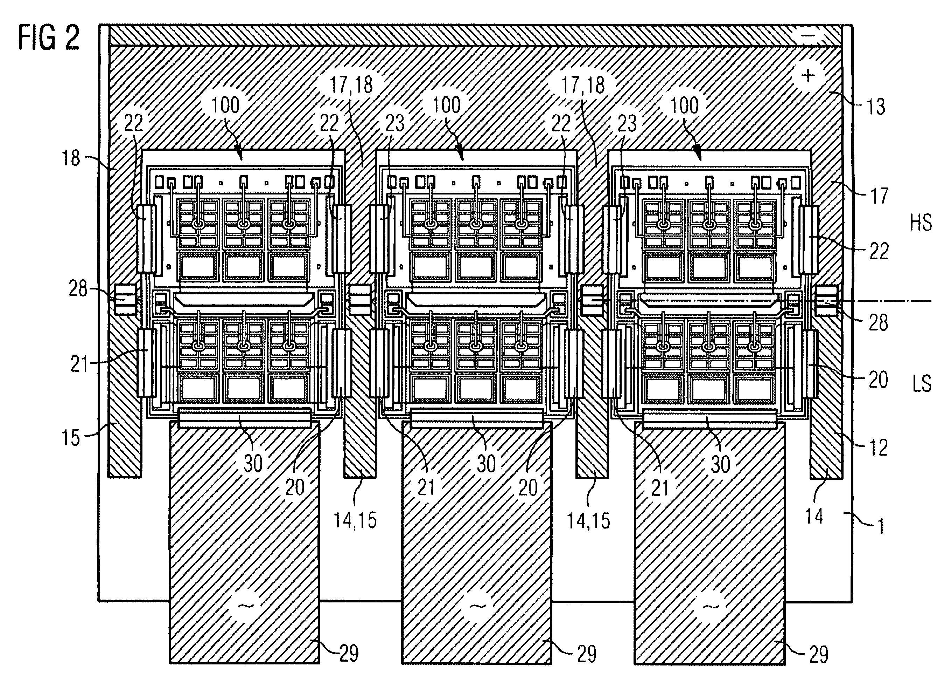

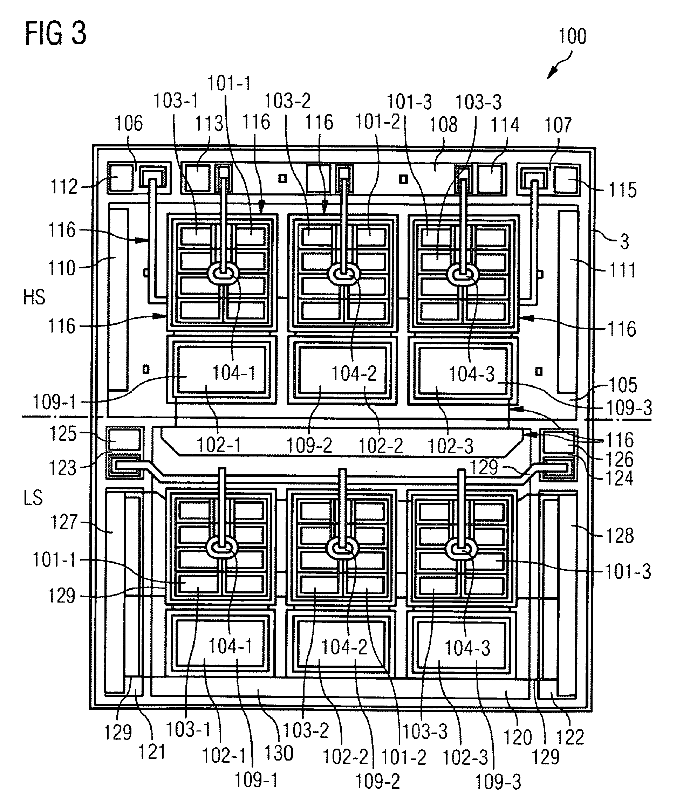

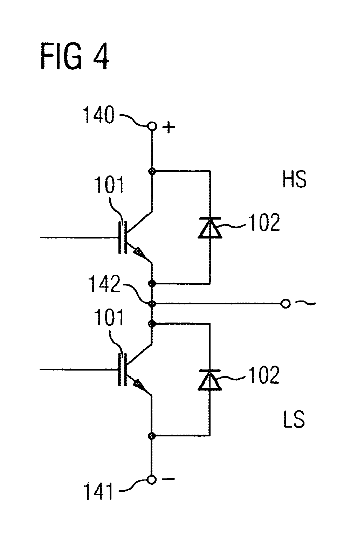

Fig. 2 zeigt ein Ausführungsbeispiel der erfindungsgemäßen Anordnung in einer Draufsicht, wobei die Anordnung für eine dreiphasige Wechselrichtung dient. Demgemäß umfasst die Anordnung drei Chipmodule 100. Eine vergrößerte Darstellung ist in Fig. 3 dargestellt. Ein Chipmodul 100 bildet eine Halbbrücke aus, wobei ein elektrisches Ersatzschaltbild in Fig. 4 dargestellt ist.

In bekannter Weise umfasst eine Halbbrücke zwei seriell miteinander verschaltete Halbleiterschaltelemente 101, wie z.B. einen IGBT oder einen MOSFET. Jedem der beiden Halbleiterschaltelemente 101 ist ein Halbleitergleichrichtelement 102, z.B. eine (Freilauf-)Diode, parallel geschaltet. Diese kann bei MOSFETs auch entfallen. Die miteinander verschalteten Lastanschlüsse der Halbleiterschaltelemente 101 sind mit einem Anschluss 142 gekoppelt, welcher, wie aus der nachfolgenden Beschreibung näher ersichtlich werden wird, mit einer Stromschiene 29 der Anordnung in Fig. 2 elektrisch verbunden ist. Das Halbleiterschaltelement 101, das mit einem Anschluss 140, welcher mit einem positiven Potential beaufschlagt ist, verbunden ist, wird als High-Side-Schaltelement bezeichnet. Das Halbleiterschaltelement 101, das mit einem Anschluss 141, der mit einem negativen Potential beaufschlagt ist, verbunden ist, wird als Low-Side-Schaltelement bezeichnet. Wie aus der späteren Beschreibung deutlich werden wird, ist der Anschluss 140 mit der Stromschiene 13 der Anordnung in Fig. 2 und der Anschluss 141 mit der Stromschiene 12 der Anordnung in Fig. 2 H verbunden.

Fig. 3 zeigt eine mögliche Realisierung einer solchen erfindungsgemäßen Halbbrücke. Das High-Side-Schaltelement HS des in Fig. 3 gezeigten Chipmoduls 100 umfasst drei parallel geschaltete Halbleiterschaltelemente 101-1, 101-2 und 101-3. Jedem der Halbleiterschaltelemente 101-1, 101-2, 101-3 ist ein Halbleitergleichrichtelement 102-1, 102-2, 102-3 parallel geschaltet. Die Anzahl an parallel geschalteten Halbleiterschaltelementen und den jeweils zugeordneten Freilaufdioden ist willkürlich gewählt. Prinzipiell kann die Anzahl an Halbleiterschaltelementen beliebig gewählt werden. Die Halbleiterschaltelemente und die Halbleitergleichrichtelemente 101-1, 101-2, 101-3 und 102-1, 102-2 und 102-3 sind jeweils mit ihrer rückseitigen Kontaktfläche auf einer gemeinsamen Kontaktfläche 105, welche auf dem Träger 3 aufgebracht ist, angeordnet und kontaktiert.

Jedes der Halbleiterschaltelemente 101-1, 101-2, 101-3 weist auf seiner von dem Träger 3 abgewandten Vorderseite Anschlussflächen 103-1, 103-2 und 103-3 auf, welche Lastanschlüsse darstellen. Diese Anschlussflächen 103-1, 103-2 und 103-3 umgeben jeweils eine Anschlussfläche 104-1, 104-2 und 104-3, welche Steueranschlüsse darstellen und jeweils über eine Leiterzugstruktur mit einer gemeinsamen Kontaktfläche 108 elektrisch leitend verbunden sind. Auf der Kontaktfläche 108 sind Anschlussflächen 113, 114 zur Beaufschlagung mit einem elektrischen Potential vorgesehen.

Die Halbleitergleichrichtelemente 102-1, 102-2 und 102-3 weisen auf ihrer Vorderseite Anschlussflächen 109-1, 109-2 und 109-3 auf. Diese stellen Lastanschlüsse der Halbleitergleichrichtelemente dar.

Auf der Kontaktfläche 105 sind an gegenüberliegenden Seiten der parallel zueinander angeordneten Halbleiterbauelemente 101 und 102 Anschlussflächen 110 und 111 vorgesehen, welche zur elektrischen Verbindung mit den Verbindungslaschen 23 und 22 zu der Stromschiene 13 dienen.

Benachbart zu der Kontaktfläche 108 sind symmetrisch jeweils Kontaktflächen 106 und 107 vorgesehen, welche jeweils eine Anschlussfläche 112 und 115 aufweisen. Diese Anschlussflächen 112 und 115 dienen für eine Sensierungsfunktion.

Zur elektrischen Verbindung der Anschlussflächen 103-1, 103-2 und 103-3 mit den Anschlussflächen 109-1, 109-2 und 109-3 sowie zur Kontaktierung weiterer Anschlussflächen ist in planarer Verbindungstechnologie eine Leiterzugstruktur 116 auf die Oberfläche des High-Side-Schaltelements HS aufgebracht. Diese flächige Leiterzugstruktur ist mit den Kontaktflächen 106 und 107 für die Sensierungsfunktion und andererseits mit einer Kontaktfläche 120 des Low-Side-Halbleiterbauelements LS verbunden. Die Kontaktflächen 106 und 107 sind ebenfalls an die Leiterzugstruktur 116 elektrisch angeschlossen.

Auf der dem Low-Side-Schaltelement LS zugeordneten Kontaktfläche 120 sind die Halbleiterschaltelemente 101-1, 101-2, 101-3 sowie die jeweils parallel geschalteten Freilaufdioden 102-1, 102-2 und 102-3 elektrisch leitend angeordnet. Die Anschlussflächen 104-1, 104-2 und 104-3 der Halbleiterschaltelemente sind über eine Leiterzugstruktur mit Kontaktflächen 123, 124 verbunden, welche jeweils eine Anschlussfläche 125 und 126 zur Beaufschlagung mit einem Steuersignal aufweisen. Die Leiterzugstruktur verläuft hierbei isoliert gegenüber der Kontaktfläche 120. Die Anschlussflächen 103-1, 103-2 und 103-3 der Halbleiterschaltelemente 101-1, 101-2 und 101-3 sowie die Anschlussflächen 109-1, 109-2 und 109-3 der Halbleitergleichrichtelemente 102-1, 102-2 und 102-3 sind über eine Leiterzugstruktur 129 mit gegenüberliegend der Kontaktfläche 120 angeordneten und von dieser elektrisch isolierten Kontaktflächen 121 und 122 verbunden. Die Kontaktflächen 121 und 122 weisen jeweils Anschlussflächen 127 bzw. 128 auf, welche zur elektrischen Verbindung mit den Verbindungslaschen 20 und 21 zu der Stromschiene 12 dienen.

Auf der Kontaktfläche 120 ist ferner eine Anschlussfläche 130 für eine Verbindungslasche 30 zu der Stromschiene 29, welche den Ausgang der Halbbrücke darstellt, vorgesehen. Die Anschlussfläche 130 erstreckt sich hierbei quer zur Erstreckungsrichtung der Anschlussflächen 127, 128 und nimmt vorzugsweise die gesamte Breite der Kontaktfläche 120 in Anspruch.

Es versteht sich aus der vorangegangenen Beschreibung und dem Ziel, sowohl das High-Side-Schaltelement HS als auch das Low-Side-Schaltelement LS mit symmetrischen Strömen zu beaufschlagen, dass die Kontaktflächen 121 und 122 des Low-Side-Schaltelements LS auf gleichem Potential sind, ebenso wie die Anschlussflächen 110 und 111 auf der Kontaktfläche 105 des High-Side-Schaltelements HS.

Fig. 2 zeigt die Anordnung, bei der drei Chipmodule 100 auf dem Trägerkörper 1 aufgebracht sind. Wie aus der Draufsicht unschwer zu erkennen ist, sind die Stromschienen 12 und 13 beispielsweise voneinander isoliert übereinander angeordnet, wobei sich jeweilige Schenkel 14, 15, 17, 18 fingerförmig neben den benachbarten Chipmodulen 100 erstrecken. Aus der Draufsicht geht weiterhin gut hervor, dass die unmittelbar mit dem Trägerkörper verbundene Stromschiene 12 sich über die gesamte Länge der Chipmodule 100 auf dem Trägerkörper 1 hinaus erstreckt, während die auf der Stromschiene 12 aufgebrachte Stromschiene 13 in etwa an der Grenze zwischen High-Side- und Low-Side-Schaltelement HS, LS endet. Hierdurch sind sowohl Anschlussflächen an den Schenkeln 14 und 15 der Stromschiene 12 als auch an den Schenkeln 17, 18 der Stromschiene 13 geschaffen. Im Bereich dieser Schenkel sind jeweils die Verbindungslaschen 20 und 21, welche die Stromschiene 12 kontaktieren, sowie die Verbindungslaschen 22 und 23, welche die Stromschiene 13 kontaktieren, zu erkennen. Die den Ausgang der Anordnung bildenden Stromschienen 29 sind über Verbindungslaschen 30 mit den Anschlussflächen 130 eines jeweiligen Chipmoduls (vergleiche Fig. 3) kontaktiert. Im Gegensatz zu herkömmlichen Drahtbrücken erstrecken sich die Verbindungslaschen 20, 21, 22, 23, 30 nach Möglichkeit über die gesamte Breite ihrer jeweiligen Anschlussflächen.

Die nicht erfindungsgemäße Ausgestaltung der übereinander angeordneten und voneinander elektrisch isolierten Stromschienen 12, 13, welche jeweils sich längs der Chipmodule 100 erstreckende Schenkel aufweisen, erlaubt eine symmetrische Stromeinspeisung. Dies wird auch durch die in den Fig. 2 und 3 gezeigte geometrische Anordnung von Halbleiterschalt- und Halbleitergleichrichtelement begünstigt. Diese sind längs einer Achse angeordnet, welche parallel zu den Schenkeln der Stromschienen 12, 13 verläuft.

Die flächig ausgebildeten Stromschienen 12, 13 erlauben ferner die Aufbringung von Kondensatoren 28, welche bevorzugt durch eine Schweißverbindung einerseits mit dem Schenkel 15 bzw. 14 der Stromschiene 12 und dem Schenkel 18 bzw. 17 der Stromschiene 13 verbunden ist.

In einer alternativen Variante können die erste und die zweite Stromschiene 13, 14 sowie die dritte Stromschiene 29 auch auf einer Seite des Trägerkörpers 1 angeordnet sein.

Die erfindungsgemäße Anordnung erlaubt eine besonders kompakte Aufbautechnik elektronischer Leistungsteile für Antriebe, insbesondere für DC-AC- und AC-DC-Inverter sowie für DC-DC-Konverter für mobile Antriebe, z.B. in einem Fahrzeug.

Entsprechend der großflächigen Kontaktierung der Halbleiterbauelemente, der Verwendung des Leitermaterials Kupfer für die Stromschienen und die Verbindungslaschen sowie der vergleichsweise großen Leitungsquerschnitte der galvanisch abgeschiedenen Leiterzugstrukturen aus Kupfer und der geschweißten Verbindungslaschen aus Kupfer zu den Lastanschlüssen, können die elektrischen Durchleitungsverluste und damit die Eigenerwärmung gering gehalten werden. Lokale Temperaturspitzen können vermieden werden. Dies begünstigt insbesondere den sicheren Betrieb bei plötzlichen Überströmen in einem Fehlerverhalten. Zusätzlich sind die Stromschienen (sog. Lastanschlussschienen) auch geeignet, entstehende Abwärme aus Leitungsverlusten abzuführen, da das bevorzugt verwendete Material Kupfer eine Wärmeleitfähigkeit von ca. 400 W/m*K aufweist.

Die hohe Zuverlässigkeit wird jedoch nicht nur durch die Reduktion der Durchleitungsverluste und der daraus resultierenden Reduktion der Eigenerwärmung erreicht. Sowohl Schweißverbindungen als auch die großflächigen, galvanisch verstärkten Leiterzugstrukturen der planaren Verbindungstechnologie der Halbleiterbauelemente sowie eventuell weiterer passiver Bauteile, des Substrats und der Lastanschlüsse zeigen eine höhere elektrische Lastwechsel- und Temperaturschock-Festigkeit als die aus dem Stand der Technik bekannten Module.

Da insbesondere die Verbindungslaschen zwischen der Trägeranordnung mit Kupfer-Kontaktflächen und den Verbindungsschienen ebenfalls in Kupfer oder einer Kupferlegierung ausgeführt sind, existiert an den Anschlussgrenzflächen kein Unterschied im thermischen Ausdehnungskoeffizienten, wodurch die Beständigkeit gegen Temperaturzyklen erhöht ist.

Eingebrachte Vibrationen, z.B. bei einem Einsatz in der Nähe eines Verbrennungsmotors, oder aufgrund der Pulsation einer Kühlvorrichtung, führen entsprechend dem kompakten, planaren Aufbau, den flächigen Kontaktierungen sowie den kurzen Verbindungen zwischen den Modulen der Lastanschlussverschienung nicht zu einer Schwingungsanregung der Komponenten.

Die niederinduktive Verdrahtung mittels breiter, galvanisierter Leiter sowie die symmetrische Stromführung reduzieren die üblicherweise auftretenden Streuinduktivitäten.

Schließlich stellen die Kompaktheit und die geringe Bauhöhe der vorgeschlagenen Anordnung einen Vorteil für die Integration bei mobilen Antrieben dar, wie z.B. bei einer motornahen Montage in Hybridfahrzeugen.

Die flächige Anbindung der Stromschienen bzw. Lastanschlüsse an den Trägerkörper ist vorteilhaft für die Entwärmung der Stromschienen. Die flächige, coplanare Anordnung der positiven und negativen Verschienung ergibt eine niederinduktive Verbindung und unterdrückt daher Spannungsspitzen.

Die Zuführung der positiven und negativen Verschienung zu den Substraten erfolgt jeweils von den Seiten eines Chipmoduls. Hierdurch ergibt sich eine homogene Stromführung und damit eine homogene Temperaturverteilung auf dem Chipmodul. Lokale "Hot-Spots" werden unterdrückt und somit die Zuverlässigkeit des Aufbaus erhöht. Die Verschienung der drei Phasen (vergleiche Fig. 2) ist symmetrisch ausgeführt und damit liegt ein elektrisch symmetrisches Verhalten der Anordnung vor. Dies ist insbesondere bezüglich der Reduktion von EMV-Störungen vorteilhaft.

## Patentansprüche

1. Anordnung mit zumindest einem ersten und zweiten Halbleiterbauelement (8; 101-1, 101-2, 101-3), die insbesondere Leistungshalbleiterbauelement zur Leistungssteuerung hoher Ströme sind, bei der
- das zumindest eine Halbleiterbauelement (8; 101-1, 101-2, 101-3) je wenigstens zwei getrennt voneinander angeordnete elektrische Anschlussflächen aufweist und auf einem gemeinsamen Trägerkörper (1) elektrisch isoliert von diesem angeordnet ist,
- auf dem Trägerkörper (1) neben dem zumindest einen Halbleiterbauelement (8; 101-1, 101-2, 101-3) und von diesem zumindest einen Halbleiterbauelement (8; 101-1, 101-2, 101-3) elektrisch isoliert eine erste und eine zweite Stromschiene (12, 13) befestigt sind, und
- eine elektrische Anschlussfläche des zumindest einen Halbleiterbauelements (8; 101-1, 101-2, 101-3) elektrisch mit der ersten Stromschiene (12, 13) verbunden ist und eine andere elektrische Anschlussfläche dieses Halbleiterbauelements (8; 101-1, 101-2, 101-3) elektrisch mit der zweiten Stromschiene (12, 13) verbunden ist, wobei
- die erste und/oder die zweite Stromschiene (12, 13) Abschnitte aufweisen, die an gegenüberliegenden Seiten dieses Halbleiterbauelements (8; 101-1, 101-2, 101-3) angeordnet sind, wobei die mit der betreffenden Stromschiene (12, 13) elektrisch verbundene Anschlussfläche von beiden Abschnitten mit einem Strom beaufschlagt wird,
**dadurch gekennzeichnet,**
**dass** das erste und das zweite Halbleiterbauelement (8, 101-1, 101-2, 101-3) in der Anordnung zu einer Halbbrücke verschaltet sind
wobei
- eine elektrische Anschlussfläche des ersten Halbleiterbauelements (8; 101-1, 101-2, 101-3) elektrisch mit der ersten, einem elektrischen Pol zugeordneten, Stromschiene (12, 13) verbunden ist,
- eine elektrische Anschlussfläche des zweiten Halbleiterbauelements (8; 101-1, 101-2, 101-3) elektrisch mit der zweiten, dem zum einen elektrischen Pol entgegen gesetzten anderen elektrischen Pol zugeordneten, Stromschiene (12, 13) verbunden ist, und
- die andere elektrische Anschlussfläche des ersten Halbleiterbauelements (8; 101-1, 101-2, 101-3) und die andere elektrische Anschlussfläche des zweiten Halbleiterbauelements (8; 101-1, 101-2, 101-3) mit einer Verbindungslasche (30) elektrisch mit einer dritten Stromschiene (29) verbunden ist.

2. Anordnung nach Anspruch 1, bei der die Abschnitte der ersten und/oder zweiten Stromschiene (12, 13) Schenkel (14, 15; 17, 18) der betreffenden Stromschiene (12, 13) sind, die mit einem Joch (16; 19) der betreffenden Stromschiene (12, 13) U-förmig verbunden sind.

3. Anordnung nach Anspruch 2, bei der die Schenkel (14, 15; 17, 18) und das Joch (16; 19) einstückig ausgebildet sind.

4. Anordnung nach einem der vorherigen Ansprüche, bei der die dritte Stromschiene (29) isoliert auf dem Trägerkörper (1) und abschnittsweise zwischen den gegenüberliegend des Halbleiterbauelements (8; 101-1, 101-2, 101-3) angeordneten Abschnitten der ersten und/oder zweiten Stromschiene (12, 13) vorgesehen ist.

5. Anordnung nach einem der vorherigen Ansprüche, bei der eine elektrische Verbindung einer der Anschlussflächen des zumindest ersten Halbleiterbauelements (8; 101-1, 101-2, 101-3) über zwei ein- oder mehrteilige Verbindungslaschen (20, 21; 22, 23) aus je einem gebogenen oder gefalzten Metallblech erfolgt, welche jeweils mit ihrem einen Ende über eine Schweißverbindung mit einem der gegenüberliegenden Abschnitte einer der Stromschienen (12, 13) verbunden sind.

6. Anordnung nach Anspruch 5, bei der die zwei Verbindungslaschen (20, 21; 22, 23) mit ihrem anderen Ende jeweils mit einer von dem Trägerkörper (1) elektrisch isolierten Zwischen-Kontaktfläche (5, 7) oder mit einer auf der Oberfläche der Anordnung aufgebrachten Leiterzugstruktur (26, 27) verschweißt sind.

7. Anordnung nach Anspruch 6, bei der eine elektrische Verbindung zwischen der Zwischen-Kontaktfläche (5, 7) und der einen Anschlussfläche des zumindest ersten Halbleiterbauelements (8; 101-1, 101-2, 101-3) über eine auf der Oberfläche der Anordnung aufgebrachte Leiterzugstruktur (26, 27) erfolgt.

8. Anordnung nach Anspruch 6 oder 7, bei der die Zwischen-Kontaktfläche (5, 7) zwischen einem der Abschnitte der ersten und/oder zweiten Stromschiene (12, 13) und dem zumindest ersten Halbleiterbauelement (8; 101-1, 101-2, 101-3) angeordnet ist.

9. Anordnung nach einem der Ansprüche 6 bis 8, bei der eine der Zwischen-Kontaktflächen durch eine Kontaktfläche ausgebildet ist, auf der das zumindest erste Halbleiterbauelement (8; 101-1, 101-2, 101-3) elektrisch leitend angeordnet ist.

10. Anordnung nach einem der Ansprüche 6 bis 8, bei der eine der Zwischen-Kontaktflächen von einer Kontaktfläche elektrisch isoliert ist, auf der das zumindest erste Halbleiterbauelement (8; 101-1, 101-2, 101-3) elektrisch leitend angeordnet ist.

11. Anordnung nach einem der Ansprüche 5 bis 10, bei der die Verbindungslaschen (20, 21; 22, 23) aus einem dem Material der Stromschienen (12, 13) entsprechenden Material gebildet sind.

## Claims

1. Arrangement with at least one first and second semiconductor component (8; 101-1, 101-2, 101-3), which in particular are power semiconductor components for controlling the power of high currents, in which
- the at least one semiconductor component (8; 101-1, 101-2, 101-3) in each case has at least two connection surfaces arranged separately from each other and is disposed on a common substrate (1) electrically isolated from the latter,
- attached to the substrate (1), as well as the at least one semiconductor component (8; 101-1, 101-2, 101-3) and electrically insulated from the at least one semiconductor component (8; 101-1, 101-2, 101-3), are a first and a second bus bar (12, 13), and
- an electrical connection surface of the at least one semiconductor component (8; 101-1, 101-2, 101-3) is electrically connected to the first bus bar (12, 13) and another electrical connection surface of this semiconductor component (8; 101-1, 101-2, 101-3) is electrically connected to the second bus bar (12, 13),
wherein
- the first and/or the second bus bar (12, 13) have sections which are arranged on opposing sides of this semiconductor component (8; 101-1, 101-2, 101-3), wherein the connection surface connected electrically to the bus bar (12, 13) concerned has a current applied to it from both sides, **characterised in that**,
the first and the second semiconductor component (8, 101-1, 101-2, 101-3) are connected in the arrangement into a half bridge
wherein
- an electrical connection surface of the first semiconductor component (8; 101-1, 101-2, 101-3) is electrically connected to the first bus bar (12, 13) assigned to an electrical pole,
- an electrical connection surface of the second semiconductor component (8; 101-1, 101-2, 101-3) is electrically connected to the second bus bar (12, 13) assigned to the other electrical pole opposed to an electrical pole, and
- the other electrical connection surface of the first semiconductor component (8; 101-1, 101-2, 101-3) and the other electrical connection surface of the second semiconductor component (8; 101-1, 101-2, 101-3) is electrically connected to a third bus bar (29) by a connector (30).

2. Arrangement according to claim 1, in which the sections of the first and/or second bus bar (12, 13) are limbs (14, 15; 17, 18) of the bus bar concerned (12, 13), and are connected to a yoke (16; 19) of the relevant bus bar (12, 13) in a U-shape.

3. Arrangement according to 2, in which the limbs (14, 15; 17, 18) and the yoke (16; 19) are embodied in one piece.

4. Arrangement according to one of the preceding claims, in which the third bus bar (29) is provided insulated on the substrate (1) and in sections between the sections of the first and/or second bus bars (12, 13) arranged opposite the semiconductor component (8; 101-1, 101-2, 101-3).

5. Arrangement according to one of the preceding claims, in which an electrical connection of one of the connection surfaces of the at least first semiconductor component (8; 101-1, 101-2, 101-3) is made via two single or multi-part connector (20, 21; 22, 23) made from a bent or folded metal sheet in each case, which is connected in each case by its one end via a welded connection to one of the opposite sections of one of the bus bars (12, 13).

6. Arrangement according to claim 5, in which the two connectors (20, 21; 22, 23) are welded by their other end in each case to an intermediate contact surface (5, 7) electrically insulated from the substrate (1) in each case or to a conductor path structure (26, 27) applied to the surface of the arrangement.

7. Arrangement according to claim 6, in which an electrical connection between the intermediate contact surface (5, 7) and the one connecting surface of the at least first semiconductor component (8; 101-1, 101-2, 101-3) is made via a conductor path structure (26, 27) applied to the surface of the arrangement.

8. Arrangement according to claim 6 or 7, in which the intermediate contact surface (5, 7) is arranged between one of the sections of the first and/or second bus bar (12, 13) and the at least one first semiconductor component (8; 101-1, 101-2, 101-3).

9. Arrangement according to one of claims 6 to 8, in which one of the intermediate contact surfaces is embodied by a contact surface on which the at least one first semiconductor component (8; 101-1, 101-2, 101-3) is disposed electrically-conducting.

10. Arrangement according to one of claims 6 to 8, in which one of the intermediate contact surfaces is electrically insulated from a contact surface, on which the at least first semiconductor component (8; 101-1, 101-2, 101-3) is disposed electrically-conducting.

11. Arrangement according to one of claims 5 to 10, in which the connectors (20, 21; 22, 23) are formed from a material corresponding to a material of the bus bars (12, 13).

## Revendications

1. Ensemble comportant au moins un premier et deuxième composants à semi-conducteur (8 ; 101-1, 101-2, 101-3), qui sont en particulier des composants à semi-conducteur de puissance pour la commande de puissance de courants de haute intensité, dans lequel
- l'au moins un composant à semi-conducteur (8 ; 101-1, 101-2, 101-3) présente au moins deux surfaces de connexion électrique espacées l'une de l'autre et est disposé sur un corps support (1) commun, dont il est isolé électriquement,
- une première et une deuxième barres conductrices (12, 13) sont fixées sur le corps support (1) à côté dudit au moins un composant à semi-conducteur (8 ; 101-1, 101-2, 101-3) et isolées électriquement dudit au moins un composant à semi-conducteur (8 ; 101-1, 101-2, 101-3), et
- une surface de connexion électrique dudit au moins un composant à semi-conducteur (8 ; 101-1, 101-2, 101-3) est reliée électriquement à la première barre conductrice (12, 13) et une autre surface de connexion électrique de ce composant à semi-conducteur (8 ; 101-1, 101-2, 101-3) est reliée électriquement à la deuxième barre conductrice (12, 13),
- la première et/ou la deuxième barres conductrices (12, 13) comportant des tronçons disposés sur des côtés opposés de ce composant à semi-conducteur (8 ; 101-1, 101-2, 101-3), la surface de connexion reliée électriquement à la barre conductrice concernée (12, 13) étant alimentée avec un courant par les deux tronçons,
**caractérisé en ce que**
le premier et le deuxième composants à semi-conducteur (8 ; 101-1, 101-2, 101-3) sont connectés en demi-pont dans ledit ensemble,
- une surface de connexion électrique du premier composant à semi-conducteur (8 ; 101-1, 101-2, 101-3) étant reliée électriquement à la première barre conductrice (12, 13), associée à un pôle électrique,
- une surface de connexion électrique du deuxième composant à semi-conducteur (8 ; 101-1, 101-2, 101-3) étant reliée électriquement à la deuxième barre conductrice (12, 13), associée à l'autre pôle électrique opposé audit un pôle électrique, et
- l'autre surface de connexion électrique du premier composant à semi-conducteur (8 ; 101-1, 101-2, 101-3) et l'autre surface de connexion électrique du deuxième composant à semi-conducteur (8 ; 101-1, 101-2, 101-3) étant reliées électriquement à une troisième barre conductrice (29) par une patte de connexion (30).

2. Ensemble selon la revendication 1, dans lequel lesdits tronçons de la première et/ou deuxième barre conductrice (12, 13) sont des branches (14, 15 ; 17, 18) de la barre conductrice concernée (12, 13), reliées en U à une culasse (16 ; 19) de la barre conductrice concernée (12, 13).

3. Ensemble selon la revendication 2, dans lequel les branches (14, 15 ; 17, 18) et la culasse (16 ; 19) sont réalisées en une seule pièce.

4. Ensemble selon l'une des revendications précédentes, dans lequel la troisième barre conductrice (29) est prévue de manière isolée sur le corps support (1) et par portions entre les tronçons placés en regard du composant à semi-conducteur (8 ; 101-1, 101-2, 101-3) de la première et/ou deuxième barre conductrice (12, 13).

5. Ensemble selon l'une des revendications précédentes, dans lequel une connexion électrique de l'une des surfaces de connexion au moins du premier composant à semi-conducteur (8 ; 101-1, 101-2, 101-3) s'effectue via deux pattes de connexion (20, 21 ; 22, 23) en une ou plusieurs parties formées chacune d'une tôle métallique courbe ou repliée, lesquelles, chacune par l'une de leurs extrémités, sont reliées par l'intermédiaire d'une soudure à l'un des tronçons opposés de l'une des barres conductrices (12, 13).

6. Ensemble selon la revendication 5, dans lequel les deux pattes de connexion (20, 21 ; 22, 23) sont soudées chacune par leur autre extrémité sur une surface de contact intermédiaire (5, 7) isolée électriquement du corps support (1) ou sur une structure de pistes conductrices (26, 27) déposée sur la surface dudit ensemble.

7. Ensemble selon la revendication 6, dans lequel une connexion électrique entre la surface de contact intermédiaire (5, 7) et ladite une surface de connexion au moins du premier composant à semi-conducteur (8 ; 101-1, 101-2, 101-3) s'effectue via une structure de pistes conductrices (26, 27) déposée sur la surface dudit ensemble.

8. Ensemble selon la revendication 6 ou 7, dans lequel la surface de contact intermédiaire (5, 7) est placée entre l'un des tronçons de la première et/ou deuxième barre conductrice (12, 13) et au moins le premier composant à semi-conducteur (8 ; 101-1, 101-2, 101-3).

9. Ensemble selon l'une des revendications 6 à 8, dans lequel l'une des surfaces de contact intermédiaires est formée par une surface de contact sur laquelle au moins le premier composant à semi-conducteur (8 ; 101-1, 101-2, 101-3) est disposé d'une manière électroconductrice.

10. Ensemble selon l'une des revendications 6 à 8, dans lequel l'une des surfaces de contact intermédiaires est isolée électriquement d'une surface de contact sur laquelle au moins le premier composant à semi-conducteur (8 ; 101-1, 101-2, 101-3) est disposé d'une manière électroconductrice.

11. Ensemble selon l'une des revendications 5 à 10, dans lequel les pattes de connexion (20, 21 ; 22, 23) sont formées d'un matériau correspondant au matériau des barres conductrices (12, 13).
